# EUROPÄISCHE PATENTANMELDUNG

(11) **EP 3 236 462 A2**
(43) Veröffentlichungstag der Anmeldung: **25.10.2017**
(21) Anmeldenummer: 17167181.1
(22) Anmeldetag: 20.04.2017
(51) Int. Cl.: G09G 3/3208, H05B 33/08

(54) **LEUCHTDIODENANORDNUNG, VERFAHREN ZUM BETRIEB EINER LEUCHTDIODENANORDNUNG, OLED-DISPLAY UND VERFAHREN ZUM BETRIEB EINES OLED-DISPLAYS**

(30) Priorität: 20.04.2016 DE 102016206681
(71) Anmelder: Technische Universität Dresden, 01069 Dresden (DE)
(72) Erfinder: Fries, Felix Simon, 01067 Dresden (DE); Fröbel, Markus, 01640 Coswig (DE); Lenk, Simone, 01159 Dresden (DE); Reineke, Sebastian, 01099 Dresden (DE)
(74) Vertreter: Loock, Jan Pieter

(57) **Zusammenfassung**

Es wird ein Verfahren zum Betrieb einer Leuchtdiodenanordnung vorgeschlagen, wobei die Leuchtdiodenanordnung eine erste OLED mit einer ersten Abstrahlcharakteristik und eine zweiten OLED mit einer von der ersten Abstrahlcharakteristik abweichenden zweiten Abstrahlcharakteristik aufweist und wobei an die erste und die zweite OLED eine elektrische Wechselspannung angelegt wird.

## Beschreibung

### Stand der Technik

Die vorliegende Erfindung geht aus von einer Leuchtdiodenanordnung umfassend mehrere organische Leuchtdioden, sogenannte "OLED" (engl. organic light-emitting diodes). Grundsätzlich sind organische Leuchtdioden aus dem Stand der Technik, wie beispielsweise der Druckschrift DE 10 2009 048 604 A1, hinlänglich bekannt.

Eine organische Leuchtdiode umfasst mehrere organische Halbleiterschichten zwischen zwei Elektroden. Durch Anlegen einer elektrischen Spannung an die Elektroden werden von der Kathode Elektronen injiziert und von der Anode Löcher bereitgestellt. Die Elektronen und Löcher driften vertikal durch die Halbleiterschichten aufeinander zu und rekombinieren miteinander. Dabei bilden sie kurzzeitig einen gebundenen Zustand, den man als Exziton (Elektronen-Loch-Paar) bezeichnet. Beim Zerfall des Exziton wird Licht einer definierten Wellenlänge ausgestrahlt. Die Farbe bzw. Wellenlänge des ausgestrahlten Lichts hängt von der Beschaffenheit des organischen Materials in der Rekombinationszone ab. Die Rekombinationszone liegt vorzugsweise innerhalb der sogenannten Emitterschicht, welche gezielt mit Farbstoffmolekülen dotiert ist, um beim Zerfall des Exziton Licht einer bestimmten Wellenlänge (Farbe) zu erzeugen. Das Farbstoffmolekül ist entweder ein fluoreszierender oder ein phosphoreszierender Emitter, der verschiedene Anregungszustände d.h. verschiedene Molekülorbitale einnehmen kann. Das Exziton stellt dann den angeregten Zustand des Farbstoffmoleküls dar. Beim Übergang vom angeregten Zustand zurück in den Grundzustand wird, je nach Energieabstand zwischen angeregtem Zustand und Grundzustand, ein Photon entsprechender Wellenlänge ausgesandt. Durch Variation der Farbstoffmoleküle kann der Energieabstand gezielt verändert werden.

Organische Leuchtdioden erfahren sowohl in der Anwendung als auch in der Forschung eine große Aufmerksamkeit, weil sie neben einer vergleichsweise hohen Effizienz und langen Lebensdauer eine gute Farbwiedergabe sicherstellen. Zudem können organische Leuchtdioden flächig, flexibel und transparent prozessiert werden, woraus sich viele potentielle Anwendungsgebiete ergeben.

In manchen Anwendungen, wie beispielsweise bei der Aus- bzw. Beleuchtung, ist die Abhängigkeit der Lichtemission vom Betrachtungswinkel θ bedeutend, wobei der Betrachtungswinkel θ der Winkel zwischen der Betrachtungsrichtung zur Flächennormalen der Haupterstreckungsebene der OLED ist, d.h. bei einer frontalen Aufsicht auf die OLED ist der Betrachtungswinkel θ = 0 Grad. Die Lichtemission in Abhängigkeit vom Betrachtungswinkel wird für OLEDs meist mit dem Lambertschen Gesetz beschrieben. Dieses besagt, dass die abgegebene Lichtstärke sich wie I = I₀ · cos θ verhält, wobei I₀ die Lichtstärke bei θ = 0 Grad ist, also senkrechte Emission entlang der Flächennormalen. Damit ergibt sich eine über den gesamten Raum konstante Leuchtdichte L. Bei bestimmten Anwendungen ist jedoch eine Abweichung vom Lambertschen Verhalten wünschenswert. Beispielsweise möchte man bei einem Lichtspot eine Betonung der senkrechten Emission (hohe Intensität bei kleinen Betrachtungswinkeln), während als indirekte Raumbeleuchtung beispielsweise besonders seitliche Emissionen (hohe Intensität bei größeren Betrachtungswinkeln) gewünscht sind.

Leuchtdioden haben durch ihre geometrischen Gegebenheiten häufig eine feste Abstrahlcharakteristik, welche sich ausschließlich durch äußere Manipulationen modifizieren lassen. Dazu finden Spiegel, spezielle optische Strahlformer oder Mikrolinsen-Arrays Anwendung. Nachteiligerweise sind alle diese Möglichkeiten sehr aufwändig und erlaubten jeweils nur eine feste Anwendung.

### Offenbarung der Erfindung

Es ist daher eine Aufgabe der vorliegenden Erfindung eine Leuchtdiodenanordnung und ein Verfahren zum Betrieb derselben zur Verfügung zu stellen, welche(s) eine flexible und leicht steuerbare Anpassung der Abstrahlcharakteristik ermöglicht, ohne dass aufwändige und kostenintensive externe Optiken erforderlich sind.

Die Aufgabe der vorliegenden Erfindung wird gelöst durch ein Verfahren zum Betrieb einer Leuchtdiodenanordnung aufweisend eine erste OLED mit einer ersten Abstrahlcharakteristik und eine zweiten OLED mit einer von der ersten Abstrahlcharakteristik abweichenden zweiten Abstrahlcharakteristik, wobei an die erste und die zweite OLED eine elektrische Wechselspannung angelegt wird.

Das erfindungsgemäße Verfahren hat gegenüber dem Stand der Technik den Vorteil, dass über eine Veränderung der Wechselspannung variabel und kontinuierlich zwischen der ersten und der zweiten OLED geschaltet werden kann. Je nach Anteilen ergibt sich damit eine Gesamtabstrahlcharakteristik der Leuchtanordnung, die entweder mehr von der ersten Abstrahlcharakteristik oder mehr von der zweiten Abstrahlcharakteristik dominiert wird. Durch gezieltes An- und Abschalten der jeweiligen OLED mit einer Frequenz, die die menschliche Wahrnehmung übersteigt, kann somit ein fließender Übergang zwischen den beiden Abstrahlcharakteristiken erzeugt werden, so dass also auch sämtliche Mischformen zwischen ersten und zweiten Abstrahlcharakteristik allein durch die Veränderung der elektrischen Wechselspannung einstellbar ist. Vorteilhafterweise werden somit keine feste Optiken, wie Linsen, benötigt, um eine gewünschte Abstrahlcharakteristik zu erhalten. Dies hat zudem den Vorteil, dass die Abstrahlcharakteristik nachträglich noch geändert und justiert werden kann, ohne dass hierfür bewegliche Elemente, wie Mikrospiegel oder dergleichen benötigt werden. Das Anlegen der Wechselspannung umfasst im Sinne der vorliegenden Erfindung insbesondere den Fall, dass die Wechselspannung einer einzigen Wechselspannungsquelle an beide OLED simultan angelegt wird. Denkbar wäre aber natürlich auch, dass zwei Wechselspannungen von zwei unterschiedlichen Spannungsquellen getrennt voneinander an jeweils eine OLED angelegt werden. Durch Variation beider Wechselspannungen im Verhältnis zueinander kann sodann das gleiche Ergebnis erzielt werden. Eine Wechselspannung im Sinne der vorliegenden Erfindung ist insbesondere jede Spannung, die über die Zeit periodisch oder nicht-periodisch variiert wird. Die Spannungsquelle kann somit im Prinzip auch eine justierbare Gleichspannungsquelle sein.

Vorteilhafte Ausgestaltungen und Weiterbildungen der Erfindung sind den Unteransprüchen, sowie der Beschreibung unter Bezugnahme auf die Zeichnungen entnehmbar.

Gemäß einer bevorzugten Ausführungsform der vorliegenden Erfindung ist vorgesehen, dass durch eine Pulsweitenmodulation der Wechselspannung die zeitlichen Leuchtanteile der ersten OLED und der zweiten OLED gesteuert werden. Die Wechselspannung weist insbesondere ein Rechteckprofil auf. Die erste und die zweite OLED sind dabei parallel aber entgegengesetzt geschaltet, so dass je nach momentaner Phasenlage der Wechselspannung stets eine der ersten und zweiten OLEDs in Sperrrichtung und die andere der ersten und zweiten OLEDs gleichzeitig in Durchlassrichtung betrieben wird. Es leuchtet somit immer nur eine der beiden ersten und zweiten OLEDs. Welche der beiden OLEDs zu einem bestimmten Zeitpunkt gerade leuchtet, hängt davon ab, ob die Spannung gerade positiv oder negativ gepolt ist. Durch eine gezielte Verlängerung oder Verkürzung des Pulsanteils im positiven oder negativen Spannungsbereich kann die Einschaltdauer und somit der zeitliche Leuchtanteil der einen oder der anderen OLED gezielt beeinflusst werden. Dies wird im Sinne der vorliegenden Erfindung als Pulsweitenmodulation bezeichnet. Die Frequenz der Wechselspannung bleibt vorzugsweise stets gleich und liegt insbesondere höher als 21 Hertz, so dass die An- und Abschaltzeiten vom menschlichen Auge nicht wahrgenommen werden. Alternativ zum Rechteckprofil wäre natürlich auch ein sägezahnförmiger oder sinusförmiger Spannungsverlauf denkbar,

Gemäß einer weiteren bevorzugten Ausführungsform der vorliegenden Erfindung ist vorgesehen, dass die Leuchtdiodenanordnung eine dritte OLED mit einer dritten Abstrahlcharakteristik und eine vierte OLED mit einer von der dritten Abstrahlcharakteristik abweichenden vierten Abstrahlcharakteristik aufweist, wobei die erste und die zweite OLED Licht einer im Wesentlichen gleichen Farbe emittieren und wobei die dritte und die vierte OLED Licht einer im Wesentlichen gleichen Farbe emittieren und wobei ferner die Farbe der dritten und vierten OLED von der Farbe der ersten und zweiten OLED abweicht und wobei an die dritte und vierte OLED eine weitere elektrische Wechselspannung angelegt wird, wobei durch das Verhältnis zwischen der Wechselspannung und weiterer Wechselspannung die Farbe der Leuchtdiodenanordnung gesteuert wird und wobei durch Pulsweitenmodulation sowohl der Wechselspannung als auch der weiteren Wechselspannung die Abstrahlcharakteristik der Leuchtdiodenanordnung gesteuert wird. In vorteilhafter Weise kann durch eine Veränderung der Pulsweiten der Wechselspannung nicht nur eine Veränderung der Abstrahlcharakteristik zwischen der ersten und zweiten OLED justiert erzielt werden, so dass Licht dieser Farbe flexibel angepasst wird. Analog durch eine Pulsweitenmodulation der weiteren Wechselspannung die Abstrahlcharakteristik des Lichts der anderen Farbe gezielt gesteuert werden. Zuletzt kann durch das Verhältnis der Einschaltzeiten der ersten/zweiten OLED einerseits und der dritten/vierten OLED andererseits die resultierende Gesamtfarbe gezielt modifiziert werden.

Ein weiterer Gegenstand der vorliegenden Erfindung zur Lösung der eingangs genannten Aufgabe ist eine Leuchtdiodenanordnung, insbesondere betrieben mit dem vorstehend beschriebenen erfindungsgemäßen Verfahren, aufweisend eine erste OLED mit einer ersten Abstrahlcharakteristik und eine zweiten OLED mit einer von der ersten Abstrahlcharakteristik abweichenden zweiten Abstrahlcharakteristik, wobei die erste und die zweite OLED mit einer gemeinsamen Wechselspannungsquelle verbunden sind.

Die erfindungsgemäße Leuchtdiodenanordnung hat analog zum vorstehend beschriebenen erfindungsgemäße Verfahren gegenüber dem Stand der Technik den Vorteil, dass die Abstrahlcharakteristik über eine Veränderung der Wechselspannung nicht nur verändert sondern sogar stufenlos justiert werden kann. Die Justierung erfolgt allein über eine Pulsweitenmodulation der Wechselspannung, so dass eine elektronische Regelung ausreichend ist und keinerlei mechanische bzw. bewegliche Komponenten, wie bewegliche Mikrospiegel erforderlich sind. Die Leuchtdiodenanordnung ist insbesondere frei von beweglichen Komponenten und umfasst ausschließlich feststehende Teile. Zudem sind keine Optiken, wie Linsen erforderlich, um die Abstrahlcharakteristik anzupassen oder für eine bestimmte Anwendung zu optimieren.

Gemäß einer bevorzugten Ausführungsform der vorliegenden Erfindung ist vorgesehen, dass die erste Abstrahlcharakteristik bei kleinen Betrachtungswinkeln, bevorzugt kleiner als 30 Grad, besonders bevorzugt kleiner als 15 Grad und besonders bevorzugt von im Wesentlichen 0 Grad, zur Flächennormalen der Haupterstreckungsebene der ersten OLED ein Intensitätsmaximum aufweist. Die zweite Abstrahlcharakteristik weist vorzugsweise bei größeren Betrachtungswinkeln, bevorzugt größer als 30 Grad, besonders bevorzugt größer als 45 Grad und besonders bevorzugt von im Wesentlichen 55 Grad, zur Flächennormalen der Haupterstreckungsebene der zweiten OLED ein Intensitätsmaximum auf. Die erste Abstrahlcharakteristik entspricht somit eher einem kollimierten Strahler, während die zweite Abstrahlcharakteristik eher einem divergenten Strahler entspricht. Je nach Anwendungsfall kann die resultierende Gesamtabstrahlcharakteristik somit zwischen einem kollimierten Strahler, einem divergenten Strahler oder Mischformen davon verstellt werden. Bei Anwendungen, die einen kollimierten Strahler benötigen, wird die anteilige Einschaltzeit der ersten OLED erhöht, während bei Anwendungen, die einen divergenten Strahler benötigen, die anteilige Einschaltzeit der zweiten OLED erhöht wird.

Die erste und die zweite OLED sind insbesondere parallel und entgegengesetzt zueinander geschaltet, so dass zu jedem Zeitpunkt immer eine der ersten und zweiten OLED in Sperrrichtung und die andere der ersten und zweiten OLED in Durchlassrichtung geschaltet ist. Beim Umpolen der Spannungen wechseln die OLEDs, so dass die andere der beiden in Sperrrichtung bzw. Durchlassrichtung geschaltet ist. Auf diese Weise leuchtet jeweils nur eine der beiden OLEDs. Die Wechselspannung weist insbesondere ein Rechteckprofil auf. Durch Pulsweitenmodulation wird die Pulsweite des positiven oder negativen Pulses und bei feststehender Frequenz somit gleichzeitig auch die Pulsweite des komplementären negativen oder positiven Pulses variiert. Das Verhältnis der Einschaltzeiten zwischen der ersten und zweiten OLED hängt daher vom Verhältnis der beiden Pulsweiten in einer Periode der Wechselspannung ab. Über das Verhältnis der Einschaltzeiten wird das Verhältnis der Abstrahlcharakteristiken und somit auch der resultierenden Gesamtabstrahlcharakteristik eingestellt. Die Leuchtdiodenanordnung weist zur Justierung der Pulsweiten der Wechselspannung vorzugsweise einen Pulsweitenmodulator auf. Die Frequenz der Wechselspannung ist vorzugsweise stets größer als 21 Hertz, damit der Betrachter kein Flimmern des Lichts wahrnimmt.

Gemäß einer weiteren bevorzugten Ausführungsform der vorliegenden Erfindung ist vorgesehen, dass die erste und die zweite OLED Licht einer im Wesentlichen gleichen Farbe emittieren, insbesondere rot, blau oder grün. Beim Verändern der Abstrahlcharakteristik verändert sich somit die Farbe des ausgestrahlten Lichts somit nicht.

Denkbar wäre aber auch, dass die erste und zweite OLED zwar Licht der im Wesentlichen gleichen Farbe, beispielsweise rot, emittieren, aber der Farbton leicht unterschiedlich ist, hellrot und dunkelrot, damit die menschliche Farbwahrnehmung beim Betrachter bei beiden OLEDs gleich ist. Auf diese Weise können leichte Farbverschiebungen zwischen erster und zweiter OLED, die aus den optischen Eigenschaften des Schichtstapels resultieren, ausgeglichen werden, so dass das ausgestrahlte Licht die gleiche Farbe hat. Alternativ ist aber auch denkbar, dass die beiden OLEDs zwar im Prinzip die gleiche Farbe, wie rot, grün oder blau, emittieren, aber der Farbton absichtlich leicht unterschiedlich ist. Beispielsweise bei der Nutzung der Leuchtdiodenanordnung zur Raumbeleuchtung: Hier könnte gewünscht sein, dass man unter kleinen Winkeln ein kaltes Weiß abstrahlt (z.B. zum Beleuchten eines Tisches) und unter hohen Winkeln ein komfortables, warmes Weiß abstrahlt (als indirektes Licht).

Gemäß einer weiteren bevorzugten Ausführungsform der vorliegenden Erfindung ist vorgesehen, dass die Leuchtdiodenanordnung eine dritte OLED mit einer dritten Abstrahlcharakteristik und eine vierte OLED mit einer von der dritten Abstrahlcharakteristik abweichenden vierten Abstrahlcharakteristik aufweist, wobei die Farbe der dritten OLED und der vierten OLED von der Farbe der ersten OLED und/oder der zweiten OLED abweicht und wobei die dritte und die vierte OLED Licht einer im Wesentlichen gleichen Farbe emittieren, insbesondere rot, blau oder grün. Vorteilhafterweise können mit der Leuchtdiodenanordnung somit zwei verschiedene Farben, beispielsweise rot und grün, rot und blau oder grün und blau, emittiert werden, wobei bei jeder Farbe zusätzlich auch noch die Abstrahlcharakteristik unabhängig justiert werden kann. Denkbar wäre beispielsweise, dass mit einer einzigen Leuchtdiodenanordnung ein Lichtbild mit einem zentralen roten Punkt umgeben von einem äußeren grünen Kreis erzeugt wird, welches kontinuierlich in einen zentralen grünen Punkt mit einem äußeren roten Kreis verändert werden kann. Die erste und zweite OLED werden dazu mit der Wechselspannung beaufschlagt, während die dritte und vierte OLED, analog zur ersten und zweiten OLED, wiederum parallel und entgegengesetzt verschaltet sind und mit einer weiteren Wechselspannung beaufschlagt werden. Zur Veränderung des Lichtbildes werden nun die Pulsweiten beider Wechselspannungen entsprechend eingestellt. Zudem kann natürlich auch die Farben miteinander vermischt werden, um aus den beiden Farben neue Farben visuell zusammen zu mischen. Die einstellbare Abstrahlcharakteristik kann sodann als gezieltes Mittel zur Erzeugung von speziellen Farbverläufen eingesetzt werden. In einer optionalen Variante wäre auch denkbar, dass die Leuchtdiodenanordnung mit passiven Optiken versehen ist und durch eine Änderung der Abstrahlcharakteristik gezielt eine passive Optik angesprochen wird. Im vorherigen Beispiel könnte beispielsweise eine Fresnel-Linse auf der Leuchtdiodenanordnung angeordnet sein, durch welche der Strahlengang des Lichts entsprechend nur dann beeinflusst wird, wenn unter größeren Betrachtungswinkeln abgestrahlt wird. Ferner kann mit Hilfe der passiven Optiken eine Abweichung von der radialsymmetrischen Abstrahlcharakteristik herbeigeführt werden. Denkbar wäre beispielsweise, dass die passive Optik derart ausgebildet ist, dass sie auf einer Seite zu noch höheren Winkeln ablenkt, während sie auf der anderen Seite das Licht weiter in Vorwärtsrichtung kollimiert. Alternativ wäre denkbar, dass nur im Zentrum der Leuchtdiodenanordnung eine klassische Streu- oder Sammellinse angeordnet ist, welche den Strahlengang des Lichts beeinflusst, wenn das Licht unter kleinen Betrachtungswinkeln abgestrahlt wird.

Gemäß einer weiteren bevorzugten Ausführungsform der vorliegenden Erfindung ist vorgesehen, dass die Leuchtdiodenanordnung eine fünfte OLED mit einer fünften Abstrahlcharakteristik und eine sechste OLED mit einer von der fünften Abstrahlcharakteristik abweichenden sechsten Abstrahlcharakteristik aufweist, wobei die Farbe der fünften OLED und der sechsten OLED von der Farbe der ersten, zweiten, dritten und/oder vierten OLED abweicht und wobei die fünfte und die sechste OLED Licht einer im Wesentlichen gleichen Farbe emittieren, insbesondere rot, blau oder grün. In vorteilhafter Weise kann die Leuchtdiodenanordnung somit auch eine dritte Farbe mit unterschiedlichen Abstrahlcharakteristiken emittieren. Die Leuchtdiodenanordnung kann somit jede beliebige weitere Farbe aus den drei Farben zusammenmischen und gleichzeitig die Abstrahlcharakteristik bei dieser zusammengemischten weiteren Farbe kontinuierlich verändern. Die erste, zweite, dritte, vierte, fünfte und/oder sechste OLED sind vorzugsweise übereinander zu einem Leuchtdiodenstapel gestapelt. Die Leuchtdiodenanordnung kann somit als Bildpunkt (auch Pixel genannt) für OLED-Displays verwendet werden.

Denkbar ist, dass der Leuchtdiodenstapel mit einer Schutzverkapselung, insbesondere eine Glasabdeckung, versehen ist, die insbesondere direkt auf den Leuchtiodenstapel aufgebracht oder unmittelbar über dem Leuchtdiodenstapel angeordnet ist. Die Leuchtdiodenanordnung kann somit vergleichsweise kompakt ausgebildet sein, weil zur Veränderung der Abstrahlcharakteristik keinerlei bewegliche Elemente, wie Mikrospiegel oder dergleichen, benötigt werden, welche ansonsten beispielsweise zwischen der obersten OLED und der Schutzverkapselung angeordnet sein müssten. Vielmehr ist die Leuchtdiodenanordnung frei von beweglichen Komponenten und umfasst ausschließlich feststehende Teile.

Für den Fachmann versteht sich von selbst, dass die vorliegende Leuchtdiodenanordnung frei skalierbar ist. Man könnte beispielsweise analog noch eine dritte OLED mit einer dritten Abstrahlcharakteristik implementieren, wobei die dritte Abstrahlcharakteristik zwischen der ersten und zweiten Abstrahlcharakteristik liegt oder Licht unter noch größeren Winkeln als die erste Abstrahlcharakteristik emittiert.

Ein weiterer Gegenstand der vorliegenden Erfindung ist ein OLED-Display aufweisend eine Mehrzahl von erfindungsgemäßen Leuchtdiodenanordnungen, wobei die Leuchtdiodenanordnungen jeweils einen Bildpunkt des OLED-Displays darstellen.

Das erfindungsgemäße OLED-Display hat gegenüber den aus dem Stand der Technik bekannten OLED-Display den Vorteil, dass nicht nur die Farbe und Helligkeit von jedem einzelnen Bildpunkt zum Anzeigen von Informationen variiert werden kann, sondern dass zusätzlich auch die Abstrahlcharakteristik vorzugsweise eines jeden einzelnen Bildpunktes insbesondere individuell eingestellt werden kann. Hierdurch eröffnen sich völlig neue Funktionalitäten für das OLED-Display. Es ist beispielsweise bekannt, Displays von Laptops oder Mobiltelefonen mit sogenannten Blickschutzfiltern (auch als Anti-Spy-Folie oder Privacy-Folie bezeichnet) zu versehen, durch welche der Bildschirminhalt nur bei frontaler Aufsicht zu sehen ist (also unter kleinen Betrachtungswinkeln) während bei seitlicher Aufsicht (also unter größeren Betrachtungswinkel) keine Bildschirminhalte erkennbar sind. Solche folienförmigen Blickschutzfilter haben unter anderem den Nachteil, dass Sie auch bei frontaler Aufsicht verhältnismäßig viel Helligkeit verdrängen, so dass die Darstellungsqualität leidet. Zudem sind bei manchen Einsätzen Blickschutzfilter wünschenswert, beispielsweise bei der Nutzung eines mobilen Gerätes in öffentlichen Verkehrsmitteln (Blickschutz-Betriebsmodus), während bei anderen Einsätzen, wie beispielsweise eine Besprechung in einer Arbeitsgruppe, eine gute Sicht auf den Bildschirm auch unter großen Betrachtungswinkeln erstrebenswert ist (Standard-Betriebsmodus). Ein schnelles Umschalten zwischen beiden Betriebsmodi ist bei bekannten Blickschutzfiltern jedoch nicht möglich. Bei dem erfindungsgemäßen OLED-Display kann für jeden Bildpunkt die Abstrahlungscharakteristik zwischen punktförmiger Abstrahlung für kleine Betrachtungswinkel und flächiger/seitlicher Abstrahlung für größere Betrachtungswinkel umgeschaltet werden. Auf diese Weise kann beispielsweise ein in das Display integrierter und elektronisch einschaltbarer Blickschutzfilter implementiert werden. Bei einem normalen Gebrauch des OLED-Displays werden für jede Farbe je nach Bedarf immer beide OLED eingesetzt (Standardmodus), so dass das Licht unter kleinen und großen Betrachtungswinkeln sichtbar ist, während im Blickschutzmodus lediglich diejenigen OLEDs einer Farbe Verwendung finden, die das Licht unter kleinen Betrachtungswinkeln emittieren, so dass das Licht nur für einen möglichst frontal auf das Display schauenden Betrachter sichtbar ist. Die Umschaltung zwischen beiden Betriebsmodi kann softwaregesteuert erfolgen.
Entsprechend ist ein weiterer Gegenstand der vorliegenden Erfindung also ein Verfahren zum Betrieb des erfindungsgemäßen OLED-Displays, wobei das OLED-Display wahlweise in einem Standard-Betriebsmodus und in einem Blickschutz-Betriebsmodus betreibbar ist, wobei im Blickschutz-Betriebsmodus in einem Bildpunkt lediglich diejenige OLED einer Farbe betrieben wird, deren Abstrahlcharakteristik ein Maximum bei kleinen Betrachtungswinkeln, bevorzugt bei im Wesentlichen 0 Grad, aufweist. Insbesondere werden diejenigen OLEDs einer Farbe, deren Abstrahlcharakteristik ein Maximum bei größeren Betrachtungswinkeln aufweisen, im Blickschutz-Betriebsmodus abgeschaltet bzw. nicht genutzt. Vorzugsweise wird im Standard-Betriebsmodus in einem Bildpunkt auch diejenigen OLEDs einer Farbe betrieben werden, deren Abstrahlcharakteristik ein Maximum bei größeren Betrachtungswinkeln, bevorzugt größer als 30 Grad aufweisen.

Ein weiterer Gegenstand der vorliegenden Erfindung ist ein Verfahren zum Betrieb des erfindungsgemäßen OLED-Displays, wobei in jedem Bildpunkt und für jede Farbe erste OLEDs mit der ersten Abstrahlcharakteristik und zweite OLEDs mit der zweiten Abstrahlcharakteristik vorgesehen sind, wobei mittels der ersten OLEDs aller Bildpunkte ein erster Bildschirminhalt auf dem OLED-Display angezeigt wird und wobei mittels der zweiten OLEDs aller Bildpunkte ein zweiter Bildschirminhalt auf dem OLED-Display angezeigt wird. Hierdurch ergibt sich eine weitere Anwendungsmöglichkeit des OLED-Displays, nämlich dass unter kleinen Betrachtungswinkel andere Bildschirminhalte (erster Bildschirminhalt) auf dem OLED-Display angezeigt werden, als unter großen Betrachtungswinkeln (Zweiter Bildschirminhalt). Hierfür werden lediglich für die ersten Bildschirminhalte diejenigen OLEDs aller Farben verwendet, die unter kleinen Betrachtungswinkel Licht emittieren, während für die zweiten Bildschirminhalte lediglich diejenigen OLEDs aller Farben Verwendung finden, die unter großen Betrachtungswinkeln Licht emittieren. Die beiden Gruppen von OLEDs brauchen lediglich nur völlig unabhängig voneinander angesteuert werden. Auf diese Weise können sich zwei Betrachter, die unterschiedliche Betrachtungswinkel auf das OLED-Display haben, ein OLED-Display teilen und trotzdem gleichzeitig unterschiedliche Inhalte ansehen. Denkbar ist beispielsweise, dass auf einem einzigen Fernseher, der das erfindungsgemäße OLED-Display umfasst, zwei unterschiedliche Kanäle gleichzeitig angezeigt werden, so dass Betrachter, die an unterschiedlichen Positionen relativ zum Fernseher sitzen, frei ihren Kanal wählen können. Der dazugehörige Ton könnte beispielsweise über Kopfhörer bereitgestellt werden. Eine solche Anwendung könnte beispielsweise in einem Flugzeug sinnvoll sein. Denkbar wäre auch, dass ein Navigationssystem eines Fahrzeugs mit dem erfindungsgemäßen OLED-Display ausgestattet ist, so dass dem Fahrer Navigationsdaten angezeigt werden können, während der Beifahrer auf dem gleichen Display Unterhaltungsinformationen, wie einen Spielfilm oder dergleichen angezeigt bekommt.

### Kurze Beschreibung der Zeichnungen

- Figur 1: zeigt eine schematische Ansicht einer Leuchtdiodenanordnung gemäß einer beispielhaften Ausführungsform der vorliegenden Erfindung.
- Figur 2a: zeigt eine erste Abstrahlcharakteristik der ersten OLED der Leuchtdiodenanordnung gemäß der beispielhaften Ausführungsform der vorliegenden Erfindung.
- Figur 2b: zeigt eine zweite Abstrahlcharakteristik der zweiten OLED der Leuchtdiodenanordnung gemäß der beispielhaften Ausführungsform der vorliegenden Erfindung.
- Figur 2c: zeigt die Quanteneffizienz in Abhängigkeit der Leuchtdichte für die erste und die zweite OLED der Leuchtdiodenanordnung gemäß der beispielhaften Ausführungsform der vorliegenden Erfindung.
- Figuren 3a und 3b: zeigen die Gesamtabstrahlcharakteristik der Leuchtdiodenanordnung gemäß der beispielhaften Ausführungsform der vorliegenden Erfindung bei einem positiven Rechteckimpuls der Wechselspannung.
- Figuren 4a und 4b: zeigen die Gesamtabstrahlcharakteristik der Leuchtdiodenanordnung gemäß der beispielhaften Ausführungsform der vorliegenden Erfindung bei einem negativen Rechteckimpuls der Wechselspannung.
- Figuren 5a und 5b: zeigen die resultierende Gesamtabstrahlcharakteristik der Leuchtdiodenanordnung gemäß der beispielhaften Ausführungsform der vorliegenden Erfindung bei einer Rechteckspannung.
- Figur 6a: zeigt eine schematische Ansicht eines OLED-Displays gemäß einer beispielhaften ersten Ausführungsform der vorliegenden Erfindung.
- Figur 6b: zeigt eine schematische Ansicht eines OLED-Displays gemäß einer beispielhaften zweiten Ausführungsform der vorliegenden Erfindung

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

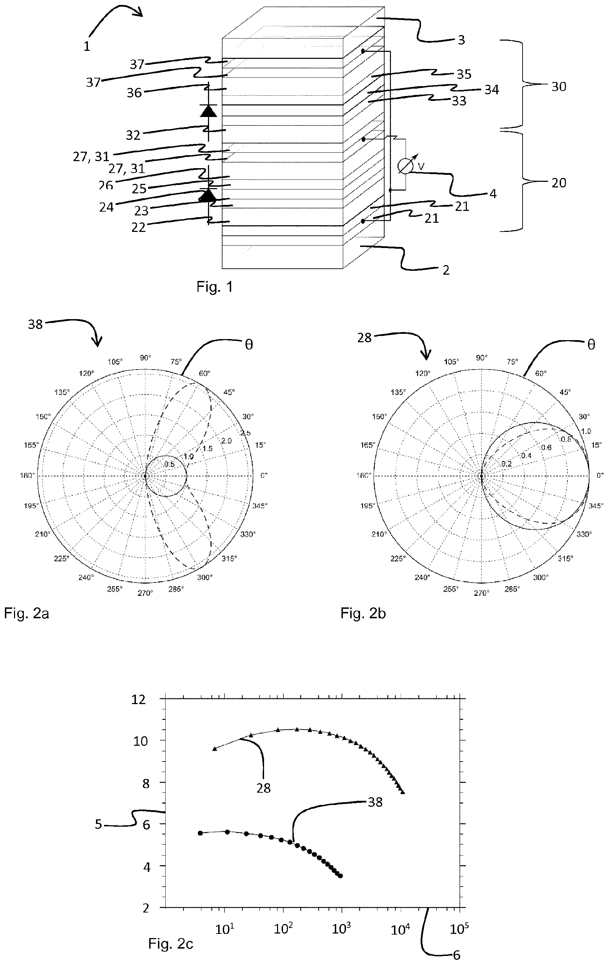

In **Figur 1** ist eine schematische Ansicht einer Leuchtdiodenanordnung 1 gemäß einer beispielhaften Ausführungsform der vorliegenden Erfindung dargestellt.

Die Leuchtdiodenanordnung 1 umfasst ein Halbleiterbauelement, welches aus organischen Schichten aufgebaut ist und auf einem Substrat 2 in Dünnschichttechnik hergestellt ist. Das bedeutet, dass die verschiedenen organischen Schichten, aus denen die Leuchtdiodenanordnung 1 aufgebaut ist, ganzflächig auf dem Glassubstrat 2 durch physikalische Gasphasenabscheidung (PVD), wie bspw. thermisches Verdampfen oder Sputtern, oder chemische Gasphasenabscheidung (CVD) erzeugt wurden.

Im vorliegenden Beispiel weist die Leuchtdiodenanordnung 1 zwei zu einem Stapel übereinander gestapelte organische Leuchtdioden, eine erste organische Leuchtdiode 20 (im Folgenden als erste OLED bezeichnet) und eine zweite organische Leuchtdiode 30 (im Folgenden als zweite OLED bezeichnet) auf.

Die erste OLED 20 ist unmittelbar auf dem Substrat 2 (Glassubstrat) angeordnet. Die erste OLED 20 ist aus einer Vielzahl von Schichten aufgebaut, welche ausgehend vom Glassubstrat 2 beispielhaft die folgenden Schichten umfasst, wobei in runden Klammern die beispielhafte Materialbezeichnung und ggf. Dotierung aufgeführt ist und wobei in eckigen Klammern jeweils beispielhaft die Schichtdicken angegeben sind: Anode 21 (Zwei Schichten: Ag [40nm], Al [40nm]), Loch-Transportschicht 22 (Spiro-TTB:F6-TCNNQ (4wt%) [285nm]), Elektronblockerschicht 23 (NPB [10nm]) und Emissionsschicht 24 (NPB:Ir(MDQ)₂(acac) (10wt%) [20nm]), Lochblockerschicht 25 (BAIq2 [10nm]), Elektronen-Transportschicht 26 (BPhen:Cs [55nm]) und Kathode 27 (Zwei Schichten: Au [2nm], Ag [7nm]). Unmittelbar auf der ersten OLED 20 ist die zweite OLED 30 angeordnet. Dabei teilen sich beide OLEDs 20, 30 eine Elektrode, so dass die Kathode 27 der ersten OLED 20 gleichzeitig die Anode 31 der zweiten OLED 30 ist. Die zweite OLED 30 ist wiederum aus einer Vielzahl von Schichten aufgebaut, welche ausgehend von der ersten OLED 20 beispielhaft die folgenden Schichten umfasst, wobei in Klammern die beispielhafte Materialbezeichnung und ggf. Dotierung aufgeführt ist und wobei in eckigen Klammern jeweils beispielhaft die Schichtdicken angegeben sind: Anode 31 (Zwei Schichten: Au [2nm], Ag [7nm]), Loch-Transportschicht 32 (Spiro-TTB:F6-TCNNQ (4wt%) [20nm]), Elektronblockerschicht 33 (NPB [10nm]) und Emissionsschicht 34 (NPB:Ir(MDQ)₂(acac) (10wt%) [20nm]), Lochblockerschicht 35 (BAIq2 [10nm]), Elektronen-Transportschicht 36 (BPhen:Cs [230nm]) und Kathode 37 (Zwei Schichten: Au [2nm], Ag [8nm]). Unmittelbar auf der zweiten OLED 30 ist eine Deckschicht 3 (NPB [80nm]) vorgesehen, die zur optischen Optimierung der ausgekoppelten Spektren dient. Optional ist oberhalb dieser Deckschicht 3 eine Verkapselung aus Glas vorgesehen, wobei die Verkapselung von der Deckschicht 3 beabstandet ist.

Solche OLEDs 20, 30 funktionieren grundsätzlich derart, dass durch Anlegen einer elektrischen Spannung an die Elektroden freie Ladungsträger bereitgestellt werden, d.h. von der Anode 21, 31 Elektronen und von der Kathode 27, 37 Elektronen. Die Transportschichten dienen dazu, diese Ladungsträger von den Elektroden zu der Emissionsschicht 24, 34 zu transportieren und deren Injektion in die Emissionsschicht 24, 34 zu begünstigen. Die Transportschicht auf der einen Seite umfasst dafür eine Loch-Transportschicht 22, 32, um Ladungsträger in Form von Löchern zur Emissionsschicht 24, 34 zu transportieren, während die Transportschicht auf der anderen Seite eine Elektronen-Transportschicht 26, 36 zur Injektion von Elektronen in die Emissionsschicht 24, 34 umfasst. Die Elektronen und Löcher driften vertikal aufeinander zu und rekombinieren innerhalb der Emissionsschicht 24, 34 miteinander. Dabei bilden sie kurzzeitig einen gebundenen Zustand, den man als Exziton (Elektronen-Loch-Paar) bezeichnet. Beim Zerfall des Exziton wird Licht einer definierten Wellenlänge ausgestrahlt. Die Farbe bzw. Wellenlänge des ausgestrahlten Lichts hängt von der Beschaffenheit des organischen Materials in der Emissionsschicht 24, 34 ab. Die beiden Blockerschichten 23, 33, 25, 35 auf jeder Seite der Emissionsschicht 24, 34 dienen dazu, die Exzitonen auf zur Lichtemission führende Emittermoleküle zu konzentrieren, wodurch die interne Quanteneffizienz optimiert wird.

Neben dem Leuchtdiodenstapel ist schematisch die Verschaltung der beiden OLEDs 20, 30 mit einer gemeinsamen Wechselspannungsquelle 4 dargestellt. Mittels der Wechselspannungsquelle 4 wird jeweils zwischen Anode 21, 31 und Kathode 27, 37 der jeweiligen OLEDs 20, 30 eine Wechselspannung 9 anlegt, welche bei den beiden OLEDs 20, 30 allerdings unterschiedlich gepolt ist. Die elektrische Verschaltung der ersten und zweiten OLED 20, 30 zeigt, dass beide OLEDs 20, 30 parallel zueinander und entgegengesetzt verschaltet sind, d.h. wenn die eine der beiden OLEDs 20, 30 in Sperrrichtung geschaltet ist, dann ist die andere der beiden OLEDs 20, 30 zwangsläufig in Durchlassrichtung geschaltet. Beide OLEDs 20, 30 werden also mit der Frequenz der Wechselspannung 9 ständig zwischen Sperrrichtung und Durchlassrichtung hin und her geschaltet. Grundsätzlich leuchten OLEDs aber nur, wenn sie in Durchlassrichtung betrieben werden. Die beiden OLEDs 20, 30 leuchten also nicht dauerhaft, sondern nur taktweise. Damit das zeitweise Erlöschen der OLEDs 20, 30 für einen Betrachter nicht als Blinken wahrgenommen wird, wird eine Wechselspannung 9 mit einer Frequenz höher als 21 Hertz verwendet.

Die beiden OLEDs 20, 30 haben ferner eine unterschiedliche Abstrahlcharakteristik. In **Figur 2b** ist eine erste Abstrahlcharakteristik 28 der ersten OLED 20 exemplarisch dargestellt, während in **Figur 2a** eine zweite Abstrahlcharakteristik 38 der zweiten OLED 30 exemplarisch dargestellt ist. In den beiden Diagrammen ist jeweils die abgestrahlte Lichtintensität in Abhängigkeit des Betrachtungswinkels θ. Der Betrachtungswinkel θ ist dabei der Winkel zwischen der Betrachtungsrichtung und der Flächennormalen der Haupterstreckungsebene der OLED, d.h. bei einer frontalen Aufsicht auf die OLED ist der Betrachtungswinkel θ = 0 Grad. Die zweite Abstrahlcharakteristik 38 der zweiten OLED 30 weist ein Maximum bei Betrachtungswinkel θ von ungefähr 55 Grad (Vgl. Figur 2a) auf, während die erste Abstrahlcharakteristik 28 der ersten OLED 20 ein Maximum bei einem Betrachtungswinkel θ von ungefähr 0 Grad aufweist (Vgl. Figur 2b). Die erste OLED 20 ist demnach mehr ein kollimierter Strahler (auch als Vorwärtsemission bezeichnet), während die zweite OLED 30 mehr einem divergenten Strahler (auch als seitliche Emission bezeichnet) ähnelt.

In **Figur 2c** sind für beide Abstrahlcharakteristiken 28, 38 die externe Quanteneffizienz 5 in Prozent gegenüber Leuchtdichte 6 in cd/m² aufgetragen. Für die seitliche Emission der zweiten OLED 30 liegt die maximale Quanteneffizienz bei 5,6%, während für die Vorwärtsemission der ersten OLED 20 eine maximale Quanteneffizienz von 10,5% gegeben ist.

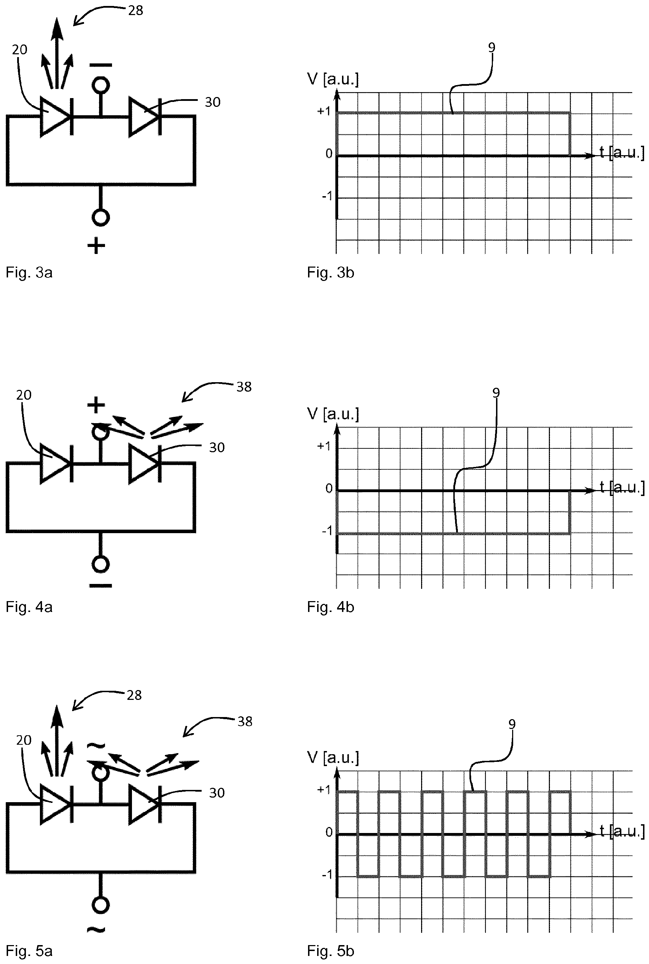

Anhand der **Figuren 3a bis 5b** wird nachfolgend die Funktionsweise der Leuchtdiodenanordnung 1 gemäß der in Figur 1 illustrierten beispielhaften Ausführungsform der vorliegenden Erfindung näher erläutert.

Es wurde bereits vorstehend beschrieben, dass lediglich diejenige OLED 20, 30 leuchtet, welche gerade in Durchlassrichtung betrieben wird. Welche OLED 20, 30 gerade in Sperrrichtung betrieben wird, hängt von der Wechselspannung 9 ab. Im vorliegenden Beispiel wird die Leuchtdiodenanordnung 1 mit einer Rechteckspannung beaufschlagt.

In Figur 3b ist nun ein Zeitintervall gezeigt, in welchem die Spannung gerade im positiven Spannungsbereich (größer null ist) liegt, also ein positiver Puls der Wechselspannung 9 anliegt. In diesem Fall ist nur die erste OLED 20 in Durchlassrichtung geschaltet und leuchtet daher, während die zweite OLED 30 in Sperrrichtung geschaltet ist und kein Licht emittiert, wie in Figur 3a schematisch illustriert ist. Die Abstrahlcharakteristik der gesamten Leuchtdiodenanordnung 1 wird demnach ausschließlich durch die erste OLED 20 bestimmt und entspricht daher der ersten Abstrahlcharakteristik 28 (Vgl. Figur 2b). Die Leuchtdiodenanordnung 1 zeigt daher ein Vorwärtsemissionsspektrum, d.h. es wird Licht mit einem Intensitätsmaximum bei Betrachtungswinkeln nahe oder gleich null emittiert. Mit anderen Worten: Die Leuchtdiodenanordnung 1 ähnelt eher einem kollimierten Strahler.

In Figur 4b ist nun ein Zeitintervall gezeigt, in welchem die Spannung gerade im negativen Bereich (kleiner null ist) liegt, also ein negativer Puls der Wechselspannung 9 anliegt. In diesem Szenario ist die zweite OLED 30 in Durchlassrichtung geschaltet, während die erste OLED 20 in Sperrrichtung geschaltet ist. Es leuchtet demnach nur die zweite OLED 30, wie in Figur 4a schematisch angedeutet. Die gesamte Abstrahlcharakteristik der Leuchtdiodenanordnung 1 wird demnach ausschließlich durch die zweite OLED 30 bestimmt und entspricht daher der zweiten Abstrahlcharakteristik 38 (Vgl. Figur 2a). Die Leuchtdiodenanordnung 1 zeigt daher ein seitliches Emissionsspektrum, d.h. es wird Licht mit einem Intensitätsmaximum bei größeren Betrachtungswinkeln emittiert. Mit anderen Worten: Die Leuchtdiodenanordnung 1 ähnelt eher einem divergenten Strahler.

Die Leuchtdiodenanordnung 1 weist nun einen Pulsweitenmodulator auf, mit welchem die zeitliche Länge der positiven und negativen Rechteckpulse gezielt eingestellt werden kann. Durch eine Modulation des Verhältnisses zwischen der zeitlichen Länge eines positiven Rechteckimpulses und der zeitlichen Länge eines negativen Rechteckimpulses in einer Periode der Wechselspannung 9 werden somit der Anteil der Leuchtdauer der ersten OLED 20 und der Anteil der Leuchtdauer der zweiten OLED 30 eingestellt. Zwangsläufig wird somit auch das Verhältnis zwischen erster Abstrahlcharakteristik 28 und zweiter Abstrahlcharakteristik 38 eingestellt.

In Figur 5b ist beispielhaft eine Wechselspannung 9 gezeigt, bei welcher die positiven Rechteckimpulse und die negativen Rechteckimpulse gleich lang sind. Die Leuchtanteile der ersten und zweiten OLED 20, 30 sind somit gleichverteilt, so dass die resultierende Gesamtabstrahlcharakteristik der Leuchtdiodenanordnung 1 in gleicher Weise durch die erste Abstrahlcharakteristik 28 und durch die zweite Abstrahlcharakteristik 38 bestimmt wird. Die Leuchtdiodenanordnung 1 emittiert Licht somit sowohl seitlich als auch in Vorwärtsrichtung.

Über den Pulsweitenmodulator können die Anteile zwischen erster und zweiter OLED nun stufenlos verstell werden, um die Gesamtabstrahlcharakteristik mehr in Richtung erster Abstrahlcharakteristik 28 oder mehr in Richtung zweiter Abstrahlcharakteristik 38 zu verschieben.

Für den Fachmann versteht sich von selbst, dass die vorliegende Leuchtdiodenanordnung 1 frei skalierbar ist. Man könnte beispielsweise analog noch eine dritte OLED mit einer dritten Abstrahlcharakteristik implementieren, wobei die dritte Abstrahlcharakteristik zwischen der ersten und zweiten Abstrahlcharakteristik 28, 38 liegt oder Licht unter noch größeren Winkeln als die erste Abstrahlcharakteristik 28 emittiert.

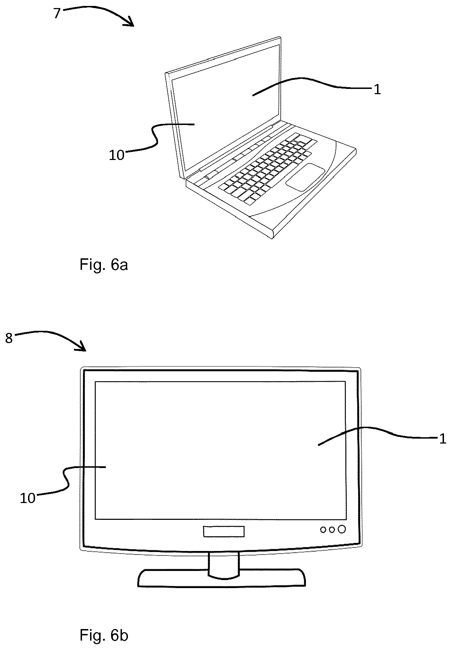

In **Figur 6a** ist ein OLED-Display 10 gemäß einer beispielhaften ersten Ausführungsform der vorliegenden Erfindung gezeigt. Im vorliegenden Beispiel ist das OLED-Display 10 in einen tragbaren Computer integriert. Das OLED-Display 10 weist für jeden Bildpunkt eine Leuchtdiodenanordnung 1 auf, wobei die Leuchtdiodenanordnung 1 für wenigstens drei verschiedene Farben jeweils eine OLED mit Vorwärtsemissionsrichtung und eine OLED mit seitlicher Emissionsrichtung aufweist, die parallel und entgegengesetzt geschaltet sind. Insgesamt sind in jedem Bildpunkt also wenigstens sechs OLEDs zu einem Stapel übereinander gestapelt. Alternativ könnten auch drei Stapel (rot, grün, blau) von jeweils zwei OLEDs (mit unterschiedlicher Abstrahlcharakteristik) nebeneinander angeordnet sein.

Das OLED-Display 10 kann nun in einem Standard-Betriebsmodus und in einem Blickschutz-Betriebsmodus betrieben werden. Im Standard-Betriebsmodus werden in jedem Bildpunkt jeweils alle OLEDs einer Farbe angesteuert, um eine Bildschirminformation auf dem OLED-Display 10 anzuzeigen. Auf diese Weise werden sowohl die OLED mit Vorwärtsemissionsrichtung als auch die OLEDs mit seitlicher Emissionsrichtung verwendet, wodurch der Bildschirminhalt bei unterschiedlichen Betrachtungswinkeln auf dem OLED-Display 10 klar und deutlich ablesbar ist. Im Blickschutz-Betriebsmodus werden in jedem Bildpunkt des OLED-Displays 10 nur noch diejenigen OLEDs einer Farbe verwendet, die hauptsächlich eine Vorwärtsemissionsrichtung aufweisen, während diejenigen OLEDs die hauptsächlich zur seitlichen Emission beitragen dauerhaft abgeschaltet werden. Auf diese Weise ist der Bildschirminhalt nur noch unter kleinen Betrachtungswinkeln sichtbar, also für denjenigen Benutzer der frontal auf den Bildschirm schaut.

In **Figur 6b** ist ein OLED-Display 10 gemäß einer beispielhaften zweiten Ausführungsform der vorliegenden Erfindung gezeigt. In diesem Beispiel ist das OLED-Display 10 in ein Fernsehgerät integriert. Das OLED-Display 10 weist für jeden Bildpunkt wiederum eine Leuchtdiodenanordnung 1 auf, wobei die Leuchtdiodenanordnung 1 für wenigstens drei verschiedene Farben jeweils eine OLED mit Vorwärtsemissionsrichtung und eine OLED mit seitlicher Emissionsrichtung aufweist, die parallel und entgegengesetzt geschaltet sind. Insgesamt sind in jedem Bildpunkt also, wie bei Figur 6a, wenigstens sechs OLEDs zu einem Stapel übereinander gestapelt. Alternativ könnten auch hier drei Stapel (rot, grün, blau) von jeweils zwei OLEDs (mit unterschiedlicher Abstrahlcharakteristik) nebeneinander angeordnet sein.

Die Steuerung des OLED-Displays 10 ist derart vorgesehen, dass mittels der ersten OLEDs 20 aller Bildpunkte, die alle eine Vorwärtsemissionsrichtung haben, ein erster Bildschirminhalt auf dem OLED-Display 10 angezeigt wird und mittels der zweiten OLEDs 30 aller Bildpunkte, die alle eine seitliche Emissionsrichtung haben, ein zweiter Bildschirminhalt auf dem OLED-Display 10 angezeigt wird. Auf diese Weise können zwei unterschiedliche Bildschirminhalte gleichzeitig auf dem einen OLED-Display 10 angezeigt werden, wobei derjenige Betrachter, der unter flachen Betrachtungswinkeln auf das OLED-Display 10 schaut, den einen Bildschirminhalt sieht, während ein anderer Betrachter, der frontal auf das OLED-Display 10 schaut, den anderen Bildschirminhalt sieht. Auf diese Weise können auf nur einem Fernseher beispielsweise zwei unterschiedliche Sendungen angesehen werden, sofern die Betrachter in einem unterschiedlichen Winkel zum Fernseher angeordnet sind.

### Bezugszeichenliste

- 1: Leuchtdiodenanordnung
- 2: Substrat
- 3: Deckschicht
- 4: Wechselspannungsquelle / Pulsweitenmodulator
- 5: Quanteneffizienz
- 6: Leuchtdichte
- 7: Computer
- 8: Fernseher
- 9: Wechselspannung / Rechteckspannung
- 10: OLED-Display
- 20: Erste OLED
- 21, 31: Anode
- 22, 32: Loch-Transportschicht
- 23, 33: Elektronblockerschicht
- 24, 34: Emissionsschicht
- 25, 35: Lochblockerschicht
- 26, 36: Elektronen-Transportschicht
- 27, 37: Kathode
- 28: Erste Abstrahlcharakteristik
- 30: Zweite OLED
- 38: Zweite Abstrahlcharakteristik
- θ: Betrachtungswinkel

## Patentansprüche

1. Verfahren zum Betrieb einer Leuchtdiodenanordnung (1) aufweisend eine erste organische Leuchtdiode (20) mit einer ersten Abstrahlcharakteristik (28) und eine zweite organische Leuchtdiode (30) mit einer von der ersten Abstrahlcharakteristik (28) abweichenden zweiten Abstrahlcharakteristik (38), wobei an die erste und die zweite organische Leuchtdiode (20, 30) eine elektrische Wechselspannung (9) angelegt wird.

2. Verfahren nach Anspruch 1, wobei durch eine Pulsweitenmodulation der Wechselspannung die zeitlichen Leuchtanteile der ersten organischen Leuchtdiode (20) und der zweiten organischen Leuchtdiode (30) gesteuert werden.

3. Verfahren nach einem der vorhergehenden Ansprüche, wobei die Wechselspannung (9) parallel an die erste und die zweite organische Leuchtdiode (20, 30) angelegt wird und/oder wobei je nach momentaner Phasenlage der Wechselspannung stets eine der ersten und zweiten organischen Leuchtdioden (20, 30) in Sperrrichtung, während gleichzeitig die andere der ersten und zweiten organischen Leuchtdioden (20, 30) in Durchlassrichtung betrieben wird.

4. Verfahren nach einem der vorhergehenden Ansprüche, wobei die erste und die zweite organische Leuchtdiode (20, 30) mit einer elektrischen Wechselspannung (9) in Form einer Rechteckspannung betrieben werden, deren Frequenz größer als 21 Hertz ist.

5. Verfahren nach einem der vorhergehenden Ansprüche, wobei Leuchtdiodenanordnung (1) eine dritte organische Leuchtdiode mit einer dritten Abstrahlcharakteristik und eine vierte organische Leuchtdiode mit einer von der dritten Abstrahlcharakteristik abweichenden vierten Abstrahlcharakteristik aufweist, wobei die erste und die zweite organische Leuchtdiode (20, 30) Licht einer im Wesentlichen gleichen Farbe emittieren und wobei die dritte und die vierte organische Leuchtdiode Licht einer im Wesentlichen gleichen Farbe emittieren und wobei ferner die Farbe der dritten und vierten organischen Leuchtdiode von der Farbe der ersten und zweiten organischen Leuchtdiode (20, 30) abweicht und wobei an die dritte und vierte organische Leuchtdiode eine weitere elektrische Wechselspannung (9) angelegt wird, wobei durch das Verhältnis zwischen der Wechselspannung (9) und weiterer Wechselspannung (9) die Farbe der Leuchtdiodenanordnung (1) gesteuert wird und wobei durch Pulsweitenmodulation sowohl der Wechselspannung (9) als auch der weiteren Wechselspannung (9) die Abstrahlcharakteristik der Leuchtdiodenanordnung (1) gesteuert wird.

6. Leuchtdiodenanordnung (1), insbesondere betrieben mit einem Verfahren nach einem der vorhergehenden Ansprüche, aufweisend eine erste organische Leuchtdiode (20) mit einer ersten Abstrahlcharakteristik (28) und eine zweite organische Leuchtdiode (30) mit einer von der ersten Abstrahlcharakteristik (28) abweichenden zweiten Abstrahlcharakteristik (38), wobei die erste und die zweite organische Leuchtdiode (20, 30) mit einer gemeinsamen Wechselspannungsquelle (4) verbunden sind.

7. Leuchtdiodenanordnung (1) nach Anspruch 6, wobei die erste Abstrahlcharakteristik (28) bei kleinen Betrachtungswinkeln, bevorzugt kleiner als 30 Grad, besonders bevorzugt kleiner als 15 Grad und besonders bevorzugt von im Wesentlichen 0 Grad, zur Flächennormalen der Haupterstreckungsebene der ersten organischen Leuchtdiode (20) ein Intensitätsmaximum aufweist.

8. Leuchtdiodenanordnung (1) nach einem der Ansprüche 6 oder 7, wobei die zweite Abstrahlcharakteristik (38) bei größeren Betrachtungswinkeln, bevorzugt größer als 30 Grad, besonders bevorzugt größer als 45 Grad und besonders bevorzugt von im Wesentlichen 55 Grad, zur Flächennormalen der Haupterstreckungsebene der zweiten organischen Leuchtdiode (30) ein Intensitätsmaximum aufweist.

9. Leuchtdiodenanordnung (1) nach einem der Ansprüche 6 bis 8, wobei die erste und die zweite organische Leuchtdiode (20, 30) parallel geschaltet sind und/oder wobei eine der ersten und zweiten organischen Leuchtdiode (20, 30) in Sperrrichtung und die andere der ersten und zweiten organischen Leuchtdiode (20, 30) in Durchlassrichtung geschaltet ist.

10. Leuchtdiodenanordnung (1) nach einem der Ansprüche 6 bis 9, wobei die Wechselspannungsquelle (4) einen Pulsweitenmodulator zur Justierung der jeweiligen Pulsweiten der Wechselspannung (9) aufweist, wobei die Frequenz vorzugsweise stets größer als 21 Hertz ist und wobei die Wechselspannung (9) vorzugsweise eine Rechteckspannung umfasst.

11. Leuchtdiodenanordnung (1) nach einem der Ansprüche 6 bis 10, wobei die erste und die zweite organische Leuchtdiode (20, 30) Licht einer im Wesentlichen gleichen Farbe emittieren, insbesondere rot, blau oder grün.

12. Leuchtdiodenanordnung (1) nach einem der Ansprüche 6 bis 11, wobei die Leuchtdiodenanordnung (1) eine dritte organische Leuchtdiode mit einer dritten Abstrahlcharakteristik und eine vierte organische Leuchtdiode mit einer von der dritten Abstrahlcharakteristik abweichenden vierten Abstrahlcharakteristik aufweist, wobei die Farbe der dritten organischen Leuchtdiode und der vierten organischen Leuchtdiode von der Farbe der ersten organischen Leuchtdiode (20) und/oder der zweiten organischen Leuchtdiode (30) abweicht und wobei die dritte und die vierte organische Leuchtdiode Licht einer im Wesentlichen gleichen Farbe emittieren, insbesondere rot, blau oder grün.

13. Leuchtdiodenanordnung (1) nach Anspruch 12, wobei die Leuchtdiodenanordnung (1) eine fünfte organische Leuchtdiode mit einer fünften Abstrahlcharakteristik und eine sechste organische Leuchtdiode mit einer von der fünften Abstrahlcharakteristik abweichenden sechsten Abstrahlcharakteristik aufweist, wobei die Farbe der fünften organischen Leuchtdiode und der sechsten organischen Leuchtdiode von der Farbe der ersten, zweiten, dritten und/oder vierten organische Leuchtdiode (20, 30) abweicht und wobei die fünfte und die sechste organische Leuchtdiode Licht einer im Wesentlichen gleichen Farbe emittieren, insbesondere rot, blau oder grün.

14. Leuchtdiodenanordnung (1) nach einem der vorhergehenden Ansprüche 6 bis 13, wobei die erste, zweite, dritte, vierte, fünfte und/oder sechste organische Leuchtdiode (20, 30) übereinander zu einem Leuchtdiodenstapel gestapelt sind.

15. Leuchtdiodenanordnung (1) nach einem der vorhergehenden Ansprüche 6 bis 14, wobei die Leuchtdiodenanordnung (1) wenigstens eine passive Optik zum Ausrichten der Abstrahlcharakteristik aufweist, wobei die passive Optik durch Änderung der Abstrahlcharakteristik ansprechbar ist.

16. OLED-Display (10) aufweisend eine Mehrzahl von Leuchtdiodenanordnungen (1) nach einem der Ansprüche 6 bis 15, wobei die Leuchtdiodenanordnungen (1) jeweils einen Bildpunkt des OLED-Displays (10) darstellen.

17. Verfahren zum Betrieb des OLED-Displays (10) nach Anspruch 16, wobei das OLED-Display (10) wahlweise in einem Standard-Betriebsmodus und in einem Blickschutz-Betriebsmodus betreibbar ist, wobei im Blickschutz-Betriebsmodus in einem Bildpunkt lediglich diejenige organische Leuchtdiode einer Farbe betrieben wird, deren Abstrahlcharakteristik ein Maximum bei kleinen Betrachtungswinkeln, bevorzugt bei im Wesentlichen 0 Grad, aufweist.

18. Verfahren nach Anspruch 17, wobei im Standard-Betriebsmodus in einem Bildpunkt auch diejenigen organischen Leuchtdioden einer Farbe betrieben werden, deren Abstrahlcharakteristik ein Maximum bei größeren Betrachtungswinkeln, bevorzugt größer als 30 Grad aufweisen.

19. Verfahren zum Betrieb des OLED-Displays (10) nach Anspruch 16, wobei in jedem Bildpunkt und für jede Farbe erste organische Leuchtdioden (20) mit der ersten Abstrahlcharakteristik (28) und zweite organische Leuchtdioden (30) mit der zweiten Abstrahlcharakteristik (38) vorgesehen sind, wobei mittels der ersten organischen Leuchtdioden (20) aller Bildpunkte ein erster Bildschirminhalt auf dem OLED-Display (10) angezeigt wird und wobei mittels der zweiten organischen Leuchtdioden (30) aller Bildpunkte ein zweiter Bildschirminhalt auf dem OLED-Displays (10) angezeigt wird.
